Europäisches Patentamt

European Patent Office

Office européen des brevets

(11) Numéro de publication: **0 293 312**
**A1**

(12) # DEMANDE DE BREVET EUROPEEN

(21) Numéro de dépôt: **88440012.8**

(22) Date de dépôt: **02.03.88**

(51) Int. Cl.⁴: $H\ 05\ K\ 3/26$

(30) Priorité: **29.04.87 FR 8706125**

(43) Date de publication de la demande:
**30.11.88 Bulletin 88/48**

(84) Etats contractants désignés:
**AT BE CH DE ES GB GR IT LI LU NL SE**

(71) Demandeur: **O.S.L. S.A.**
**Zone Industrielle 1ère avenue - 12ème rue**
**F-06510 Carros Industries (FR)**

(72) Inventeur: **Sauvan, Gérard**
**Villa No. 2 - Résidence du Chateau**
**Rue Paul Gauguin F-06800 Cagnes Sur Mer (FR)**

(74) Mandataire: **Hasenrader, Hubert et al**
**Cabinet BEAU DE LOMENIE 55, rue d'Amsterdam**
**F-75008 Paris (FR)**

(54) **Machine de nettoyage notamment pour sous-ensembles électroniques.**

(57) Machine de nettoyage, notamment pour composants électroniques, comprenant une enceinte (10) sensiblement fermée avec des fenêtres d'entrée (12) et de sortie (14), traversée par un convoyeur (16) assurant le déplacement desdits composants, et des dispositifs de nettoyage (20, 18, 30) par solvant disposés le long du trajet dudit convoyeur, ces dispositifs comprenant au moins :

- un étage de prélavage (20) par aspersion du solvant sur les composants ;

- un étage de lavage par trempage des composants dans un bain de solvant contenu dans un bac de trempage (18) ;

- un étage de rinçage (30) par aspersion de solvant sur les composants.

Des organes de chauffage (26) sont associés au bac de trempage (18) en vue de maintenir le bain de solvant en permanence en ébullition, des organes de chauffage (42) sont associés à l'étage de rinçage (30) en vue de porter le solvant en permanence au voisinage de sa température d'ébullition, et l'enceinte (10) est coiffée par une unité de condenseur (64) destinée à la recondensation des vapeurs de solvant, les condensats de ce dernier étant rassemblés dans un réservoir de solvant pur (36) pour l'alimentation de l'étage de rinçage (30), le solvant provenant de l'étage de rinçage (30) étant recueilli à une extrémité du bac de trempage (18) et évacué à l'autre extrémité, afin de maintenir dans le bac (18) un écoulement de solvant en direction contraire à celle du déplacement des composants.

Fig.1

## Description

## MACHINE DE NETTOYAGE NOTAMMENT POUR SOUS-ENSEMBLES ELECTRONIQUES

La présente invention concerne une machine de nettoyage, notamment pour sous-ensembles électroniques.

Dans les industries électroniques, on regroupe des composants sur des cartes de circuits imprimés suivant des densités de plus en plus élevées, soit du côté de la carte opposé aux circuits, soit du même côté (technologie dite des composants montés en surface : CMS ou encore du montage en FLAT PACK), soit encore des deux côtés à la fois.

Lorsque le soudage est assuré dans des machines de soudage à la vague, il convient de nettoyer les cartes après passage dans la machine de soudage afin d'en éliminer les traces de flux et les minuscules gouttes de soudure qui ont pu se détacher au cours de la soudure et risquent de provoquer des court-circuits.

Lorsque le soudage est effectué par refusion de crème à braser, cette crème à braser étant constituée de microbilles d'eutectique dans un liant formant flux, et déposée par sérigraphie sur des plages choisies de la carte, les composants sont ensuite positionnés sur la carte et celle-ci est exposée à la chaleur pour provoquer la refusion de la crème à braser et former la soudure; dans ce cas, un certain nombre de microbilles à la périphérie des plages de crème à braser échappent à la coalescence et migrent sur la carte en risquant de provoquer des court-circuits.

Fréquemment, les machines de nettoyage actuelles utilisent des solvants fluoro-carbonés et combinent un ou plusieurs des modes suivants :

- aspersion du solvant sur les cartes

- trempage des cartes dans un bain de solvant avec ou sans utilisation d'ultrasons.

Le solvant chargé d'impuretés et de produits en solution est distillé dans un distilleur accolé à la machine de nettoyage, puis le solvant pur est renvoyé vers celle-ci.

Ce recyclage du solvant est rendu nécessaire non pas tant à cause du coût du solvant mais surtout parce que l'on cherche à réduire de plus en plus l'émission à l'atmosphère des vapeurs de ces solvants fluoro-carbonés qui sont actuellement tenus pour responsables de l'érosion de la couche protectrice d'ozone entourant l'atmosphère terrestre.

Dans les machines de nettoyage fonctionnement continu, les cartes traversent la machine depuis une fenêtre d'entrée jusqu'à une fenêtre de sortie qui doivent bien entendu demeurer ouvertes pour laisser le passage aux cartes et au convoyeur qui les véhicule à travers la machine.

D'une part, ces fenêtres constituent des issues par lesquelles les vapeurs de solvant peuvent s'échapper à l'atmosphère.

D'autre part, malgré les précautions prises pour faire égoutter le solvant des cartes et du convoyeur après rinçage final, des gouttes de solvant restent fixées aux cartes et au convoyeur et sont entraînées hors de la machine par la fenêtre de sortie et leur évaporation ultérieure conduit aux inconvénients déjà cités.

Dans certaines machines, on procède à une évaporation forcée par ventilation, ce qui suppose de prévoir un étage supplémentaire à cet effet, y compris des dispositifs appropriés pour la condensation du solvant ainsi évaporé.

De plus, les distilleurs comportent un évent pour leur mise à l'atmosphère, qui constitue également une issue pour l'émission de vapeurs de solvant à l'atmosphère.

Enfin, dans l'ensemble, les machines actuelles manquent d'efficacité dans le nettoyage des cartes de circuit imprimés portant des composants montés en surface dans la mesure où l'espace (de l'ordre de 25 microns) entre ces composants et la carte est mal balayé par le solvant.

Dans le but de remédier à ces divers inconvénients, la présente invention propose une machine de nettoyage pour composants, notamment électroniques, comprenant une enceinte sensiblement fermée traversée par un trajet de déplacement pour lesdits composants et des dispositifs de nettoyage par solvant disposés le long dudit trajet, ces dispositifs comprenant au moins :

- un étage de prélavage par aspersion de solvant sur les composants ;

- un étage de lavage par trempage de composants dans un bain de solvant ; et

- un étage de rinçage par aspersion de solvant sur les composants,

caractérisée en ce qu'elle comprend des organes de chauffage associés au bain de solvant et destinés à maintenir ce dernier en permanence en ébullition, et des organes de chauffage associés à l'étage de rinçage destinés à porter le solvant en permanence au voisinage de sa température d'ébullition, et en ce que ladite enceinte est coiffée par une unité de condenseur destinée à la recondensation des vapeurs de solvant, les condensats de ce dernier étant rassemblés dans un réservoir de solvant pur pour l'alimentation de l'étage de rinçage, le solvant provenant de l'étage de rinçage étant recueilli à une extrémité du bain de trempage et évacué à l'autre extrémité, afin de maintenir dans le bain un écoulement de solvant en direction contraire à celle du déplacement des composants.

D'autres détails et avantages de l'invention apparaîtront clairement à la lecture de la description qui va suivre, en se référant aux dessins annexés dans lesquels :

- la figure 1 est une vue latérale schématique d'une machine de nettoyage selon l'invention ;

- la figure 2 est une vue en plan schématique de cette machine ; et

- la figure 3 est une vue de détail de l'une des fenêtres de la machine.

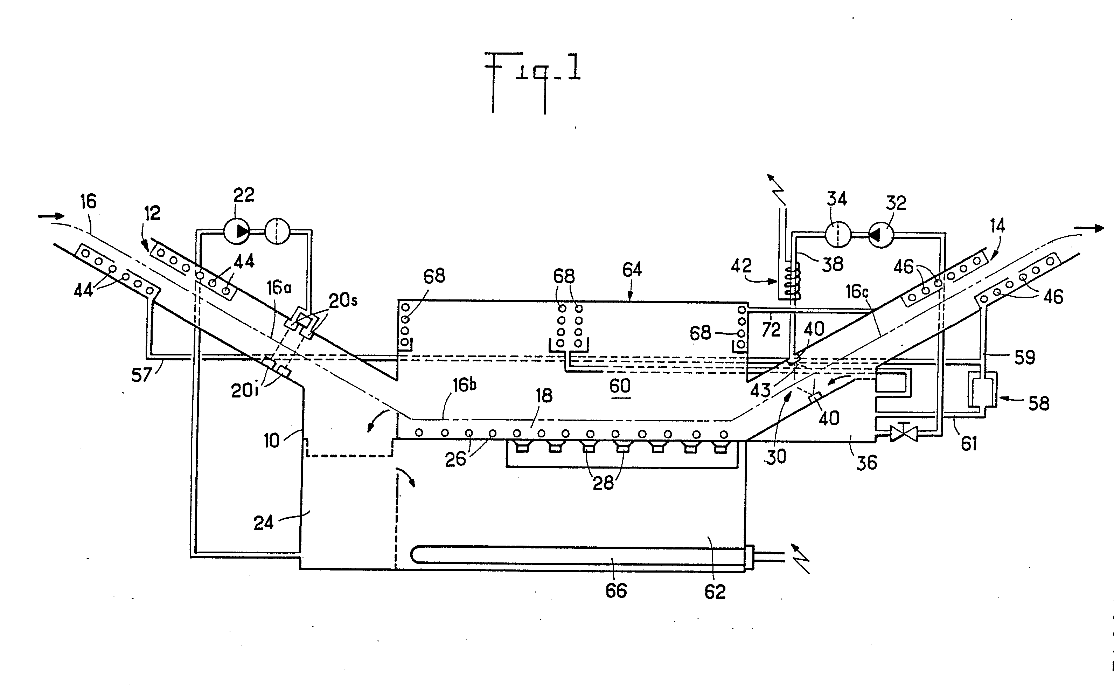

Considérant la figure 1, la machine comporte une enceinte étanche 10 avec une fenêtre d'entrée 12 et une fenêtre de sortie 14 traversées par un convoyeur 16 destiné à entraîner les cartes de circuit imprimé le long d'un trajet qui présente un tronçon incliné descendant 16a à partir de la fenêtre d'entrée 12, suivi d'un tronçon horizontal 16b qui traverse un bac 18, et d'un tronçon ascendant 16c qui traverse la fenêtre de sortie 14.

Entre la fenêtre d'entrée 12 et le bac 18, le long du tronçon descendant sont disposées des rampes d'aspersion de prélavage 20i, 20s au-dessous et au-dessus du convoyeur, au refoulement d'une pompe à haute pression 22 qui puise le solvant dans un réservoir de réception 24 recueillant le solvant des étages de nettoyage successifs comme on le verra par la suite, et le solvant étant au voisinage de son point d'ébullition ; les rampes sont conçues pour délivrer des jets "cohérents", c'est-à-dire sous forme de pinceaux étroits et sous une inclinaison choisie par rapport aux cartes afin que la quantité de mouvement du liquide frappant la surface de la carte se transforme en grande partie en une quantité de mouvement dirigée tangentiellement par rapport à la carte, ce qui permet au solvant liquide de pénétrer efficacement dans les faibles intervalles entre la carte et les composants montés en surface. D'autre part, le nombre et l'orientation des jets sont déterminés afin d'éviter un "engorgement" du liquide à la surface de la carte, ce qui nuirait à la transformation souhaitée de la quantité de mouvement du liquide nécessaire pour la pénétration dans les intervalles entre carte et composants. Enfin, une direction inclinée des jets par rapport à la carte permet d'éviter que la présence des composants fasse un effet "parapluie" ou, en d'autres termes, que les jets frappant les composants soient déviés latéralement et n'atteignent pas les zones de la carte situées au voisinage immédiat des composants. L'inclinaison des jets sera avantageusement obtenue par un montage orientable des rampes qui portent les buses d'aspersion.

A titre d'exemple, la pompe refoule un débit de 4m³/heure sous une pression de 10 bars et élimine 80 à 90% des impuretés et produits polluants de la carte.

Le long du tronçon horizontal 16b, le convoyeur et les cartes qu'il entraîne sont immergés dans un bain de solvant de faible épaisseur, contenu dans le bac 18 et s'écoulant en sens opposé à la direction de déplacement des cartes (écoulement à contre-courant) grâce à un apport de renouvellement permanent provenant de l'étage de rinçage final, comme il sera vu ci-après, et débordement du trop-plein par le bord du bac situé du côté de l'entrée. Dans le bac 18 sont disposés des éléments chauffants 26 qui maintiennent le solvant légèrement au-dessus de son point d'ébullition, de sorte que les cartes traversent une couche de solvant mise en brassage permanent par les bulles de vapeur de solvant formées par l'ébullition. De plus, sur une certaine partie de la longueur du bac, sont disposés un certain nombre de générateurs ultrasonores 28 qui rayonnent une énergie vibratoire au sein du liquide, laquelle favorise la pénétration du solvant dans les interstices les plus faibles de la carte de circuit imprimé et l'évacuation des éléments polluants présents dans ces interstices.

Dans la mesure où le solvant contenu dans le bac 18 est à son point d'ébullition, on devrait normalement s'attendre à ce que l'adjonction de générateurs ultrasonores 28 soit parfaitement superflue puisque les phénomènes habituels de micro-cavitation provoqués par la propagation des ondes ultrasonores dans le liquide ne peuvent plus se produire car de telles micro-cavités seraient alors immédiatement occupées par de la vapeur. Il a été cependant constaté que l'énergie vibratoire apportée par des générateurs ultrasonores (sous forme de trains d'ondes résonants dans le liquide bouillant ayant pour effet de déplacer les particules solides) et l'énergie de brassage due à l'ébullition donnent lieu à une synergie dont le résultat est une meilleure pénétration du solvant et une meilleure élimination des produits polluants.

Bien entendu, le pouvoir solvant du liquide est à son niveau le plus élevé puisque ce pouvoir solvant augmente avec la température.

Enfin, les cartes de circuits imprimés et le convoyeur traversant le bac sont portés à une température voisine du point d'ébullition du solvant, et les avantages de cette mise en température seront vus ultérieurement.

Le convoyeur et les cartes quittent le bac par le tronçon ascendant 16c en direction de la fenêtre de sortie 14 et traversent un étage de rinçage final 30 qui assure une aspersion de solvant pur par le dessous et le dessus des cartes.

Il convient de remarquer que ce rinçage final doit répondre à plusieurs impératifs :
- c'est la dernière occasion de déloger les impuretés, microbilles de soudure, ou produits polluants ;
- le débit de solvant pur disponible est fixé par la capacité du distilleur ;
- le rinçage ne doit pas faire diminuer la température de la carte.

La solution retenue est une pulvérisation à très haute pression (réglable par exemple de 20 à 60 bars et sous la dépendance d'un asservissement) sous un débit faible de 400l/h par exemple et à une température pratiquement égale à la température d'ébullition du solvant.

On notera au passage que grâce à la haute pression délivrée par la pompe 32, il est possible de prévoir un poste d'ultra-filtration 34 (> 5 microns) immédiatement en aval de la pompe.

Cependant, il n'est pas envisageable de chauffer le solvant dans le réservoir 36 de puisage de la pompe sinon celle-ci risquerait de caviter et de fonctionner avec un mauvais rendement.

Le puisage se fait donc "à température ambiante", c'est-à-dire la température du solvant pur tel qu'il sort du distilleur et est ramené vers le réservoir tampon 36.

Le réchauffage se fait par conséquent sur la conduite haute pression 38 en aval de la pompe et en amont des têtes 40 de pulvérisation, donc dans une zone où l'on ne risque pas de voir apparaître des phénomènes d'ébullition en raison de la haute pression qui règne dans cette conduite.

A titre d'exemple, la température d'ébullition d'un solvant préférentiel étant de 39°C à la pression atmosphérique, cette température passe à 70°C à 20 bars. On peut ainsi apporter une énergie calorifique importante très rapidement sans risquer d'atteindre un palier dû à l'apparition des premiers germes d'ébullition le long des corps de chauffe 42.

La régulation du réchauffage est pilotée à l'aide d'une sonde de température 43 placée dans les jets de solvant immédiatement en aval des têtes de pulvérisation 40, donc après intervention des phénomènes de détente et de vaporisation qui se produisent à la sortie des tetes.

On peut ainsi maintenir cette température aussi proche que possible de la température d'ébullition (39°C-0,5°C) et parfaitement constante.

Le réchauffeur 42 a également une très faible inertie grace à la faible quantité de solvant présente dans la conduite 38, ce qui permet une régulation avec des temps de réponse très brefs. Les jets produits par les tetes de pulvérisation sont de préférence sous forme de lames et orientés suivant une incidence choisie par rapport aux cartes de circuits imprimés, afin de favoriser la pénétration du liquide dans les moindres interstices entre la carte de circuits imprimés et les composants qu'elle porte.

Le liquide ainsi pulvérisé s'égoutte vers le bac 18 et maintient dans celui-ci une circulation de solvant en sens inverse du déplacement des cartes de circuits imprimés.

On notera enfin que les cartes sortent de l'étage de rinçage final 30 pratiquement à la température de vaporisation du solvant, de sorte que les quelques gouttes de solvant qui peuvent éventuellement demeurer "accrochées" aux cartes et/ou au convoyeur s'évaporent dans la zone entre l'étage de rinçage final et la fenêtre de sortie 14.

Les quelques rares gouttes de solvant non évaporées à ce stade et qui seront entraînées à l'extérieur de la machine par les cartes et/ou le convoyeur représenteront donc un pourcentage infime.

La machine assure également la recondensation et la distillation du solvant in situ, grâce aux dispositions ci-après :

a) Protection des fenêtres d'entrée 12 et sortie 14 par des condenseurs "bouchon"

Ces fenêtres sont entourées par des serpentins 44, 46 parcourus par un liquide de refroidissement et sur lesquels viennent se condenser les vapeurs de solvant, à l'image des serpentins de condensation des distilleurs.

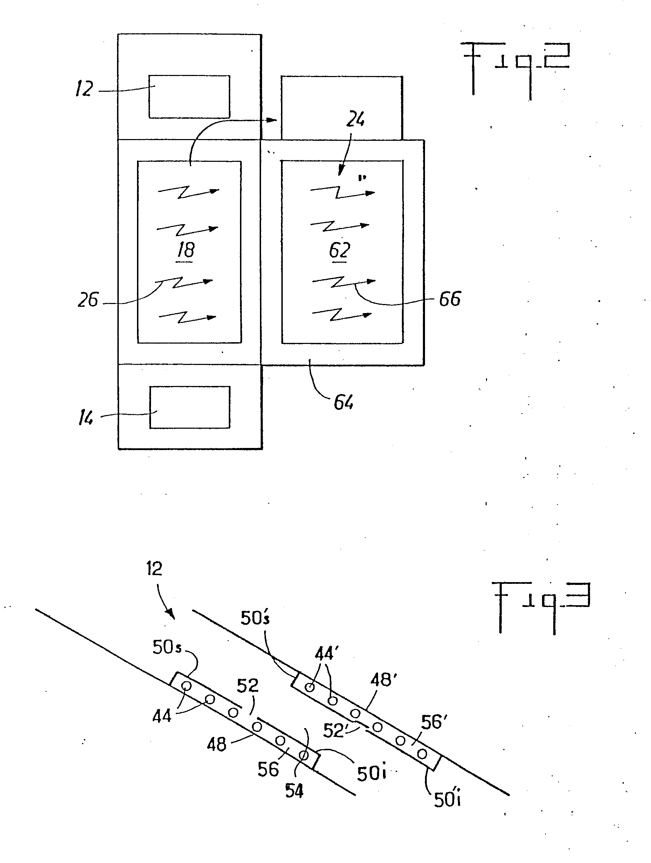

Cependant, on a prévu d'améliorer le fonctionnement et le rendement de ces condenseurs "bouchon" de la manière suivante (voir détail figure 3).

En plus de la paroi externe 48 qui entoure les serpentins, il est prévu une paroi interne 50 formée de deux tronçons de paroi qui rejoignent la paroi externe, un tronçon supérieur 50s et un tronçon inférieur 50i, ces deux tronçons étant séparés par un intervalle 52 grâce auquel il existe une communication entre la zone interne 54 de la fenêtre située à l'intérieur de la paroi interne, et la zone annulaire 56 définie entre les parois interne et externe et dans laquelle sont placés les serpentins de condenseur.

Ainsi, les vapeurs présentes dans la zone annulaire 56 se condensent rapidement sur les serpentins et ce phénomène crée une dépression dans la zone annulaire qui "aspire" positivement toutes les vapeurs qui pourraient tenter de s'échapper par la fenêtre, dés que de telles vapeurs atteignent le niveau de l'intervalle 52 de communication vers la zone annulaire.

Pour éviter la chute de gouttes de solvant condensé sur les cartes de circuit à travers l'intervalle 52' du côté où la paroi interne 50'i, 50's surplombe le convoyeur (références "prime"), on réalisera de ce côté la paroi interne d'une seule pièce, l'intervalle 52' étant défini par des ouïes, ou "crevés", dans cette paroi.

On notera que ces fenêtres d'entrée et sortie sont les seules zones de la machine où la vapeur de solvant est en contact avec l'air atmosphérique et risque de se charger avec de l'eau atmosphérique. Dans la mesure où ces fenêtres sont de petite taille, de tels entraînements d'eau sont relativement faibles et l'appareil déshydrateur 58 intégré à la machine (Fig. 1, sels hygroscopiques ou siliporites) dans le but de piéger les molécules d'eau présentes dans les condensats de vapeur provenant des fenêtres d'entrée et sortie via les conduits 57 et 59 pourra être de taille réduite avec éventuellement diminution de la fréquence de regénération du déshydrateur. En aval du déshydrateur 58, le solvant pur est ramené vers le réservoir 36 par un conduit 61.

Un autre avantage réside dans la possibilité de faire fonctionner la machine en discontinu, c'est-à-dire d'arrêter les pompes d'aspersion 22, 32 lorsqu'elles ne sont pas nécessaires.

A la remise en route des pompes se produit un léger à-coup qui aurait tendance dans une machine classique à faire remonter dans les fenêtres d'entrée et sortie le niveau de vapeur jusqu'au point de débordement hors de la machine.

Grâce aux dispositions qui précèdent, il y a absorption immédiate des vapeurs qui auraient tendance en cas d'à-coup à dépasser le niveau de l'intervalle de communication vers la zone annulaire.

b) Utilisation du volume interne de la machine en chambre de distillation

Il a été vu que le bac 18 dans lequel trempent les cartes de circuit imprimés au cours de leur nettoyage est réchauffé jusqu'à ébullition du solvant. Etant donné la grande surface de ce bac, la quantité de vapeur produite par unité de temps est importante et se répand dans tout le volume intérieur 60 de la machine au-dessus du bac.

Par ailleurs, le solvant qui s'écoule successivement dans les différents étages de la machine se rassemble finalement dans un bac de réception final 62, situé sur le côté par rapport au bac d'immersion 18 mais de telle sorte que les zones situées au-dessus du bac final 62 et du bac de trempage 18 forment une seule et même zone 60 coiffée par une unité de condenseur 64 comme il sera décrit plus loin.

On comprendra que dans la représentation schématique de la figure 1, le bac de réception final 62 n'est pas situé sous le bac de trempage 18 mais se trouve décalé latéralement, comme schématisé à la figure 2, d'un côté ou de l'autre de la machine.

Dans le bac final 62, des éléments chauffants 66 portent le solvant à ébullition et, étant donné la grande surface de ce bac, la quantité de vapeur produite par unité de temps est importante et se répand dans tout le volume intérieur 60 de la machine en se mélangeant avec les vapeurs provenant du bac d'immersion.

L'ensemble du volume de la machine est parfaitement isobare, de sorte que l'on évite des mouvements de convection parasite des vapeurs dans toute la machine.

De plus, les surfaces d'évaporation cumulées du bac d'immersion 18 et du bac final 62 sont très importantes et l'on peut réguler la puissance de chauffe dans les deux bacs de manière à produire une ébullition "douce", c'est-à-dire que le bouillonnement dû aux bulles de vapeur éclosant en surface sera modéré et on évitera ainsi l'entraînement (mécanique) avec ces vapeurs des fractions de produits volatiles non désirées ayant des points d'ébullition voisins.

La capacité d'évaporation de la machine est par exemple de 400l/heure, qu'il convient de comparer avec les capacités habituelles des distilleurs pour ces types de machines (180l/heure).

L'unité de condenseur 64 forme une coiffe couvrant la largeur totale de la machine, c'est-à-dire la largeur de la zone de nettoyage proprement dite plus la largeur du bac de réception final. Cette coiffe est obturée à son extrémité supérieure et équipée d'un grand nombre de tubes de condenseur 68 parcourus par un liquide de refroidissement.

Les vapeurs se condensent ainsi sur ces tubes 68 puis le solvant pur condensé est récupéré dans des goulottes 70 qui aboutissent au réservoir tampon 36 de solvant pur.

La machine comporte une pompe à chaleur (non représentée) dont l'évaporateur est constitué par les tubes de condenseur 68 de l'unité de condenseur 64, ainsi que par les serpentins 44 des condenseurs bouchon associés aux fenêtres d'entrée et sortie 12, 14 et dont le condenseur est constitué par les éléments chauffants 26 du bac de trempage 18 et les éléments chauffants 66 du bac de réception final 62, ainsi que par un condenseur classique à air. Une régulation appropriée assure la répartition des gaz comprimés chauds entre les éléments chauffants et le condenseur à air.

Pour permettre l'évacuation de l'air présent initialement dans le volume de la coiffe 64, celle-ci est reliée à son sommet à l'un des condenseurs d'entrée ou de sortie, par un évent 72.

Cette disposition a en outre l'avantage que tout le volume de la coiffe 64 est rempli de vapeur saturée et que tous les tubes de condenseur 68 travaillent à leur rendement maximal. En effet, si des variations du niveau de vapeur se produisent ces variations sont transférées automatiquement vers les condenseurs bouchons de l'entrée ou de la sortie.

A titre de comparaison, dans un condenseur de distilleuse classique, la partie supérieure est reliée à l'atmosphère par un évent qui constitue une source de vapeur d'eau indésirable comme il a déjà été vu.

De plus, seuls les tubes de condenseur situés le plus bas baignent dans de la vapeur insaturée et fonctionnent à rendement réduit. Ces derniers tubes sont connus dans les appareils classiques sous le nom de tubes de "garde".

On comprendra que ces diverses caractéristiques procurent des économies substantielles à deux égards :

En premier lieu, il n'est pas besoin d'adjoindre à la machine une unité de distillation séparée, ce qui en diminue le coût et, dans une certaine mesure, l'encombrement.

En second lieu, l'énergie calorifique apportée au solvant pour le porter au voisinage de son point d'ébullition aux fins d'améliorer le nettoyage n'a pas besoin d'être apportée à nouveau pour sa distillation.

Enfin, la machine comporte diverses autres caractéristiques destinées à diminuer les entraînements de solvant hors de la machine, ainsi qu'à améliorer la qualité du nettoyage, comme notamment l'utilisation d'un convoyeur à tapis grillagé.

En effet, dans la structure des convoyeurs à chaîne habituellement utilisés dans les machines connues, on trouve pour chaque maillon un axe creux, et ces axes constituent autant de réservoirs qui se remplissent de solvant à la traversée du bac d'immersion et il est pratiquement impossible d'évacuer ce solvant avant la sortie par la fenêtre de sortie, de sorte qu'une quantité non négligeable de solvant finit ainsi par s'échapper à l'atmosphère.

Par contre, dans la structure de convoyeur à tapis grillagé, les seuls endroits où des gouttelettes de solvant peuvent encore rester piégées à la sortie de la machine sont les noeuds des mailles du grillage, ce qui représente une quantité nettement inférieure.

Mieux encore, dans la machine ici décrite, le tapis grillagé est scindé en deux tapis partiels de faible largeur (50 mm) qui supportent les cartes de circuits imprimés par leurs bordures latérales seulement. Grâce à ceci, le nombre de noeuds de maille est encore diminué ainsi que par voie de conséquence l'entraînement de gouttes de solvant.

De plus, les surfaces inférieures des cartes de circuits imprimés ne sont pas masquées par le tapis grillagé et peuvent être nettoyées efficacement.

Bien que dans cette description on ait fait uniquement mention du nettoyage de cartes de circuits imprimés, il va de soi que la machine de nettoyage trouvera de nombreuses applications pour le nettoyage de :
- composants électriques
- pièces et ensembles de mécanique de précision
- pièces et ensembles optiques,

cette liste étant non limitative.

La machine est avantageusement commandée par un microprocesseur qui intègre toutes les données de fonctionnement (vitesses, débits, températures, pression) et commande les différents équipements suivant des valeurs de consigne choisies et/ou des programmes de fonctionnement prédéterminés.

On notera enfin que les transducteurs 18 destinés à produire les ultrasons sont situés dans une zone à l'air libre et qu'il n'est pas besoin de prendre des mesures particulières pour les protéger contre une atmosphère saturée de vapeurs de solvants.

De plus, la partie inférieure de la machie située au-dessous du bac de trempage est totalement libre et peut permettre le passage du brin de retour d'un convoyeur général lorsque cette machine de nettoyage est intégrée à une ligne complète de production (postes d'assemblage - machine de soudage - machine de nettoyage) qui comporte un tel convoyeur général.

## Revendications

1. Machine de nettoyage, notamment pour composants électroniques, comprenant une enceinte (10) sensiblement fermée avec des fenêtres d'entrée (12) et de sortie (14), traversée par un convoyeur (16) assurant le déplacement desdits composants, et des dispositifs de nettoyage (20, 18, 30) par solvant disposés le long du trajet dudit convoyeur, ces dispositifs comprenant au moins :
- un étage de prélavage (20) par aspersion du solvant sur les composants ;
- un étage de lavage par trempage des composants dans un bain de solvant contenu dans un bac de trempage (18) ;
- un étage de rinçage (30) par aspersion de solvant sur les composants,
caractérisée en ce qu'elle comprend des organes de chauffage (26) associés au bac de trempage (18) et destinés à maintenir le bain de solvant en permanence en ébullition, et des organes de chauffage (42) associés à l'étage de rinçage (30) destinés à porter le solvant en permanence au voisinage de sa température d'ébullition, et en ce que ladite enceinte (10) est coiffée par une unité de condenseur (64) destinée à la recondensation des vapeurs de solvant, les condensats de ce dernier étant rassemblés dans un réservoir de solvant pur (36) pour l'alimentation de l'étage de rinçage (30), le solvant provenant de l'étage de rinçage (30) étant recueilli à une extrémité du bac de trempage (18) et évacué à l'autre extrémité, afin de maintenir dans le bac (18) un écoulement de solvant en direction contraire à celle du déplacement des composants.

2. Machine selon la revendication 1, caractérisée en ce qu'elle comprend des générateurs ultrasonores (28) associés au bac de trempage (18).

3. Machine selon l'une ou l'autre des revendications 1 et 2, caractérisée en ce qu'elle comprend un bac de réception final (62) du solvant mis en oeuvre à l'étage de prélavage, et un dispositif de chauffage (66) associé audit bac de réception final (62) et destiné à porter ledit solvant à ébullition.

4. Machine selon la revendication 3, caractérisée en ce que ledit bac de réception final (62) est placé latéralement par rapport au bac de trempage (18), l'unité de condenseur (64) coiffant à la fois le bac de trempage (18) et le bac de réception final (62).

5. Machine selon l'une quelconque des revendications précédentes, caractérisée en ce que les fenêtres d'entrée (12) et sortie (14) de l'enceinte (10) sont munies de condenseur bouchon.

6. Machine selon la revendication 5, caractérisée en ce que lesdits condenseurs bouchon consistent en des serpentins (44, 46) de condenseur s'étendant dans une zone annulaire (56) définie entre une paroi externe (48) entourant lesdits serpentins et une paroi interne (50) formée de deux tronçons, respectivement un tronçon supérieur (50s) et un tronçon inférieur (50i) séparés par un intervalle (52).

7. Machine selon la revendication 6, caractérisée en ce que l'unité de condenseur (64) est obturée à son extrémité supérieure et communique par un évent (72) avec l'un des condenseurs bouchon.

8. Machine selon l'une quelconque des revendications 5 à 7, caractérisée en ce que les condenseurs bouchon sont reliés au réservoir de solvant pur (36) par des conduits (57, 59, 61) sur lesquels est interposé un appareil déshydrateur (58).

9. Machine selon l'une quelconque des revendications 1 à 8, caractérisée en ce que le dispositif de réchauffage (42) associé à l'étage de rinçage final par aspersion (30) est placé sur un conduit de refoulement (38) en aval d'une pompe haute pression (32) et en amont des têtes d'aspersion (40).

10. Machine selon l'une quelconque des revendications 1 à 9, caractérisée en ce que le convoyeur (16) des composants est un convoyeur à tapis grillagé.

11. Machine selon la revendication 10, caractérisée en ce que le convoyeur (16) à tapis grillagé est formé de deux tapis partiels supportant les composants latéralement.

Fig.1

0293312

Fig.2

Fig.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 204 609 (OUTILLAGES SCIENTIFIQUES ET DE LABORATOIRES) * Colonne 3, ligne 4 - colonne 4, ligne 45; figure 1 * --- | 1,2,5 | H 05 K 3/26 |
| Y | EP-A-0 104 633 (HONEYWELL INC.) * Page 3, lignes 13-34; page 4, ligne 9 - page 6, ligne 13; page 7, lignes 7-28; figure 2 * --- | 1,2,5 | |
| A | EP-A-0 123 630 (ULTRASONS ANNEMASSE) * Page 6, ligne 32 - page 7, ligne 1; page 7, ligne 16 - page 8, ligne 16; page 10, ligne 1 - page 14, ligne 31; figures 1,3-5 * --- | 1-5,8 | |
| A | FR-A-2 507 918 (THE HTC CORP.) * Page 5, lignes 9-18 * --- | 1,5 | |
| A | PT WERKTUIGBOUW, vol. 32, no. 1, janvier 1977, pages 46-47, Rijswijk, NL: "Gemechaniseerd (ultrasoon) wassen" * Figures; article en entier * ----- | 2 | |

**DOMAINES TECHNIQUES RECHERCHES (Int. Cl.4)**

H 05 K
B 08 B
C 23 G

Le présent rapport a été établi pour toutes les revendications

| Lieu de la recherche | Date d'achèvement de la recherche | Examinateur |
|---|---|---|
| LA HAYE | 21-08-1988 | SCHUERMANS N.F.G. |